# EUROPÄISCHE PATENTSCHRIFT

(11) **EP 1 100 297 B1**
(45) Veröffentlichungstag und Bekanntmachung des Hinweises auf die Patenterteilung: **29.06.2005**
(21) Anmeldenummer: 00890289.2
(22) Anmeldetag: 20.09.2000
(51) Int. Cl.: H05K 3/32

(54) **Lösbare Befestigung eines Anschlusskontaktes auf einer Leiterbahn eines Schaltungsträgers**
Releasably contacting a contactlead onto a conductive path of a circuit board
Connexion amovible d'un élément de contact sur une piste d'une plaquette de circuit

(30) Priorität: 10.11.1999 AT 189899
(43) Veröffentlichungstag der Anmeldung: 16.05.2001
(73) Patentinhaber: ELECTROVAC, FABRIKATION ELEKTROTECHNISCHER SPEZIALARTIKEL GESELLSCHAFT M.B.H., 3400 Klosterneuburg (AT)
(72) Erfinder: Nagl, Christian, 1180 Wien (AT)
(74) Vertreter: Gibler, Ferdinand, Dipl.Ing. Dr.

(56) Entgegenhaltungen:
- EP-A- 0 347 561
- PATENT ABSTRACTS OF JAPAN vol. 1999, no. 10, 31. August 1999 (1999-08-31) & JP 11 139815 A (CANON INC), 25. Mai 1999 (1999-05-25)

## Beschreibung

Die Erfindung betrifft ein Verbindungssystem zur lösbaren Festlegung eines Anschlußkontaktes eines elektrisch/elektronischen Bauteils auf einer Leiterbahn eines Schaltungträgers; einen elektrischen/elektronischen Bauteil, umfassend zumindest einen Anschlußkontakt, der lösbar auf einer Leiterbahn eines Schaltungsträgers festlegbar ist und eine Leiterbahn aufgebracht auf einem Schaltungsträger, auf welcher ein Anschlußkontakt eines elektrischen/elektronischen Bauteiles lösbar festlegbar ist.

Nach bisher bekanntem Stand der Technik werden die Anschlußkontakte eines elektrischen/elektronischen Bauteiles mit den Leiterbahnen, mit welchen sie elektrisch und mechanisch verbunden werden sollen, verlötet. Die dabei entstehende Verbindung zwischen Bauteil und Leiterbahn ist lösbar, sodaß zum Austausch des Bauteiles -beispielsweise wenn dieser nicht mehr funktionstüchtig ist- dieser von den Leiterbahnen getrennt werden kann. Das zu dieser Trennung notwendige Lösen der Lötstellen ist insbesondere dann, wenn der Bauteil sehr viele Anschlußflächen aufweist, wie dies beispielsweise bei einem Mikroprozessor der Fall ist, relativ zeitaufwendig.

Auch beim Anlöten eines neuen, funktionstüchtigen Bauteiles muß wieder jede seiner Anschlußflächen separat mit der betreffenden Leiterbahn verlötet werden. Dies ist ebenfalls relativ zeitaufwendig, wobei noch dazu kommt, daß die Wärme, die jeder Anschlußfläche beim Verlöten zugeführt wird, zu einer Erhitzung des Bauteiles führt, was sich nachteilig auf seine Lebensdauer auswirkt. Daneben werden durch das Erhitzen der Lötstelle auch mechanische Spannungen in die Verbindung eingebracht, die die Lebensdauer der Verbindung vermindern.

Das Austauschen eines elektrischen/elektronischen Bauteiles, der direkt mit den Leiterbahnen eines Schaltungsträgers verlötet ist, stellt sich daher insgesamt als sehr aufwendig dar. Zur Zeit gewinnen Packages wie z.B. BGA und Flip-Chip immer mehr an Bedeutung, bei welchen ein Austausch eines defekten Bauteiles so gut wie unmöglich ist.

Dieses Problem ist im Stand der Technik bereits erkannt und auch schon wie folgt gelöst worden: Insbesondere zur Festlegung von integrierten Schaltkreisen auf Schaltungsträgern, vor allem von solchen mit sehr vielen Anschlußflächen, wie z.B. Mikroprozessoren, wurden Steck-Sockeln verwendet. Diese Komponenten weisen ebenfalls Anschlußflächen, nämlich genauso viele, wie der von ihnen aufzunehmende elektrische/elektronische Bauteil auf, welche Anschlußflächen direkt mit den Leiterbahnen verlötet werden. Jede Anschlußfläche ist mit einer Steckbuchse verbunden, welche jeweils zur Aufnahme eines Anschlußkontaktes des elektrischen/elektronischen Bauteiles geeignet ist. Damit alle diese Steckbuchsen gemeinsam gehandhabt werden können, sind sie mittels eines isolierenden Materiales, in der Regel Kunststoff, miteinander vergossen.

Nach dem Verlöten dieses Steck-Sockels mit den Leiterbahnen des Schaltungsträgers kann der elektrische/elektronische Bauteil nach Belieben durch einfach und schnell durchzuführendes Herausziehen und Einstecken aus diesem Sockel bzw. in diesen Sockel ausgetauscht werden.

Nachteilig ist bei dieser Lösung die Notwendigkeit des Steck-Sockels selbst. Dieser stellt eine zum elektrischen/elektronischen Bauteil hinzutretende Komponente dar, welche den Materialaufwand und damit die Gestehungskosten der elektrischen/elektronischen Schaltung erhöht. Darüberhinaus muß auch dieser Sockel mit den Leiterbahnen verlötet werden, was zeitaufwendig und aufgrund der dabei auftretenden Temperaturen möglicherweise schädlich für das Kunststoff-Material des Sockels selbst ist.

Es ist Aufgabe der vorliegenden Erfindung, ein Verbindungssystem zur lösbaren Festlegung eines Anschlußkontaktes eines elektrisch/elektronischen Bauteils auf einer Leiterbahn eines Schaltungträgers anzugeben, welches eine besonders einfache, ohne zusätzliche Komponenten auskommende Festlegung bzw. Lösung eines elektrischen/elektronischen Bauteiles auf einer bzw. von einer Leiterbahn eines Schaltungsträgers erlaubt.

Erfindungsgemäß wird dies dadurch erreicht, daß jener Oberflächen-Abschnitt des Anschlußkontaktes, welcher auf der Leiterbahn zu liegen kommt einerseits und jener Oberflächen-Abschnitt der Leiterbahn, auf welcher der Anschlußkontakt zu liegen kommt andererseits mit einer Schicht aus Kohlenstoff-Nanotubes belegt ist.

Eine weitere Aufgabe der vorliegenden Erfindung ist es, einen elektrischen/elektronischen Bauteil, umfassend zumindest einen Anschlußkontakt, der lösbar auf einer Leiterbahn eines Schaltungsträgers festlegbar ist, anzugeben, welcher Teil des obigen Verbindungssystems sein kann.

Ein erfindungsgemäßer elektrischer/elektronischer Bauteil zeichnet sich dadurch aus, daß jener Oberflächen-Abschnitt des Anschlußkontaktes, welcher auf der Leiterbahn zu liegen kommt mit einer Schicht aus Kohlenstoff-Nanotubes belegt ist.

Ein weitere Aufgabe der vorliegenden Erfindung ist es, eine Leiterbahn aufgebracht auf einem Schaltungsträger, auf welcher ein Anschlußkontakt eines elektrischen/elektronischen Bauteiles lösbar festlegbar ist, anzugeben, welche Teil des obigen Verbindungssystems sein kann.

Eine erfindungsgemäße Leiterbahn zeichnet sich dadurch aus, daß jener Oberflächen-Abschnitt der Leiterbahn, auf welchem der Anschlußkontakt des elektrischen/elektronischen Bauteiles zu liegen kommt, mit einer Schicht aus Kohlenstoff-Nanotubes belegt ist.

Kohlenstoff-Nanotubes sind sehr stabile, im wesentlichen normal zur Aufstandsfläche, auf welcher sie aufgewachsen sind, verlaufende röhrenförmige Körper. Wird eine in erfindungsgemäßer Weise mit solchen Nanotubes beschichtete Anschlußfläche auf eine mit Nanotubes beschichtete Leiterbahn gelegt und diese beiden Komponenten aneinander gedrückt, so werden die Nanotubes der einen Komponente in die Zwischenräume zwischen den Nanotubes der anderen Komponente eingeschoben, sodaß es zu einer intensiven Verzahnung der beiden Nanotube-Schichten miteinander kommt. Die Zwischenräume zwischen den Nanotubes sind sehr gering und entsprechen etwa den Durchmessern der Nanotubes, sodaß die Mantelflächen der Nanotubes sehr eng aneinander liegen. Es ergibt sich damit eine starke Haftreibung zwischen den beiden Nanotube-Schichten, welche zu einer besonders innigen mechanischen Verbindung der Anschlußfläche mit der Leiterbahn führt.

Durch das enge Anliegen der auf der Anschlußfläche festgelegten Nanotubes auf den Nanotubes der Leiterbahn ergibt sich weiters eine große Kontaktfläche zwischen der Anschlußfläche und der Leiterbahn, was in Kombination mit der guten elektrischen Leitfähigkeit von Kohlenstoff-Nanotubes zu einer sehr guten, d.h. niederohmigen elektrischen Verbindung zwischen der Anschlußfläche und der Leiterbahn führt. Neben der guten elektrischen Verbindung der Bauteile durch Nanotubes ist auch eine gute thermische Ankopplung gegeben.

Die Anschlußfläche -und mit ihr der elektrische/elektronische Bauteil- ist jederzeit durch Abheben des Bauteiles in etwa normal zur Schaltungsträger-Oberfläche verlaufender Richtung von der Leiterbahn trennbar.

Diese rein auf mechanischer Reibung basierende Verbindungstechnik braucht durch keinerlei andere Maßnahmen ergänzt werden, man kommt insbesondere völlig ohne jegliche Lötverbindung zwischen Bauteil-Anschlußfläche und Leiterbahn aus. Die durch die Nanotube-Schichten erreichte mechanische Verbindung ist elastisch, womit eine bessere Temperaturwechselbeständigkeit gegenüber einer starren Lötverbindung gegeben ist.

Um eine dauerhafte Fixierung der Bauteile herzustellen, können die erfindungsgemäß mittels der Nanotube-Schichten auf den Leiterbahnen festgelegten Bauteile wie bisher in der Elektronik üblich natürlich zusätzlich auch mit einer Vergußmasse versiegelt oder auf anderem Wege mechanisch fixiert werden, z.B. nach einem Funktionstest.

Gemäß einer bevorzugten Ausführungsform der Erfindungsgegenstände kann vorgesehen sein, daß die Kohlenstoff-Nanotubes Längen im Bereich zwischen 20 und 100µm aufweisen, wobei Längen im Bereich zwischen 20 und 50µum besonders bevorzugt sind.

Nanotubes in diesen Größen sind mit den gängigen Herstellungsverfahren problemlos herstellbar und entfalten die erörterten Effekte für die erfindungsgemäßen Zwecke in zufriedenstellendem Ausmaß.

In weiterer Ausgestaltung der Erfindung kann vorgesenen sein, daß die Kohlenstoff-Nanotubes an ihren freien Enden offen oder geschlossen sind.

Diese beide Erscheinungsformen von Kohlenstoff-Nanotubes sind gleichermaßen zur Erfüllung des erfindungsgemäßen Zweckes geeignet.

Die Erfindung wird unter Bezugnahme auf die beigeschlossenen Zeichnungen, in welchen ein besonders bevorzugtes Ausführungsbeispiel dargestellt ist, näher beschrieben. Dabei zeigt:
Fig. 1 einen auf einem Schaltungsträger 2 festgelegten elektronischen Bauteil 1 im Grundriß;
Fig.2 den elektronischen Bauteil 1 der Fig. 1 im Aufriß;
Fig.3 das in Fig.2 eingetragene Detail X in stark vergrößertem Maßstab und
Fig.4 die Darstellung gemäß Fig.3 nachdem der elektronische Bauteil 1 an den Schaltungsträger 2 angedrückt worden ist.

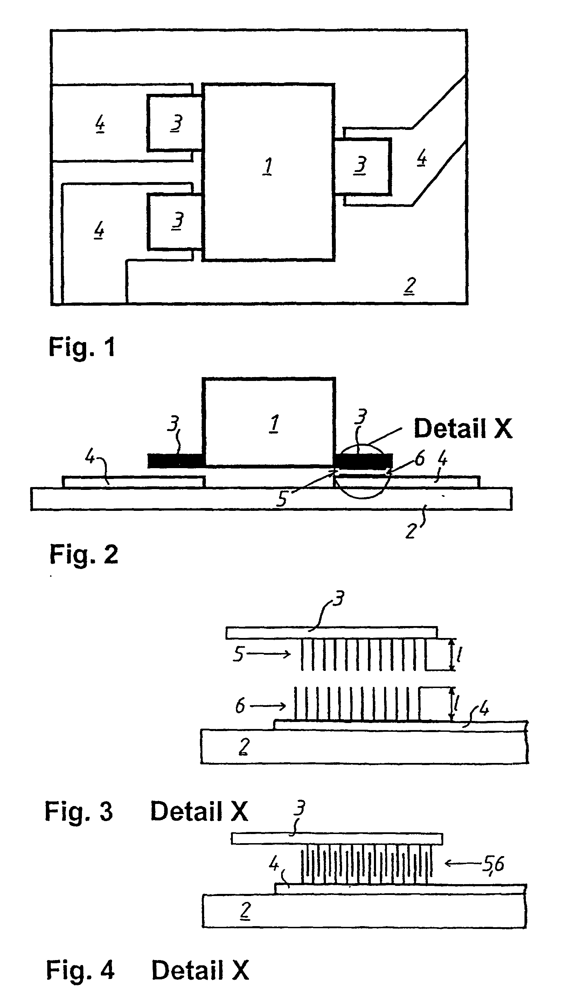

In den Fig.1 und 2 ist beispielhaft ein elektronischer Bauteil 1 in Gestalt eines in SMD (Surface Mounted Device)-Bauweise gehaltenen Transistors dargestellt. Dieser Bauteil 1 weist drei Anschlußflächen 3 auf, welche innerhalb des Transistor-Gehäuses mit Basis, Emitter und Kollektor des den eigentlichen Transistor bildenden Halbleiter-Substrates verbunden sind.

Damit eine auf dem Schaltungsträger 2 aufgebaute elektrische/elektronische Schaltung dem Transistor elektrische Signale zuführen kann, müssen dessen Anschlußflächen 3 mit den Leiterbahnen 4, die auf diesem Schaltungsträger 2 vergelegt sind, verbunden werden.

Erfindungsgemäß ist dazu ein Verbindungssystem vorgesehen, welches eine lösbare Festlegung der Anschlußkontakte 3 auf diesen Leiterbahnen 4 erlaubt. Gemäß diesem System ist vorgesehen, daß jener Oberflächen-Abschnitt des Anschlußkontaktes 3, welcher auf der Leiterbahn 4 zu liegen kommt, mit einer Schicht 5 aus Kohlenstoff-Nanotubes belegt ist. Genauso ist auch jener Oberflächen-Abschnitt der Leiterbahn 4, auf welcher der Anschlußkontakt 3 zu liegen kommt, mit einer Schicht 6 aus Kohlenstoff-Nanotubes belegt.

Kohlenstoff-Nanotubes sind an sich im Stand der Technik bekannt, es sind dies bienenwabenförmig aufgebaute, zylindrische Röhren aus sp²-Kohlenstoff. Je nach Herstellungsbedingungen unterscheidet man SWNT (Single Wall Nanotubes) oder MWNT (Multiwalled Nanotubes). Die freistehenden Enden der Nanoröhren sind unter den gebräuchlichen Synthesebedingungen durch Halbkugeln, welche durch den Einbau von genau sechs pentagonalen Einheiten in die hexagonale Graphit-Struktur entstehen, verschlossen. Wird zur Herstellung der Nanotubes ein CVD-Verfahren sowie ein Metallkatalysator eingesetzt, können die entstehenden Nanotubes auch durch Metallkappen abgeschlossen sein. Das wissenschaftliche und in der Folge industrielle Interesse an solchen Nanostrukturen beruht auf ihren hervorragenden mechanischen und elektronischen Eigenschaften. Die Grössenordnung derartiger Strukturen bewegen sich im nm- (Durchmesser)/ µm-Bereich (Länge), welche besonders auf dem Gebiet der Mikroelektronik technologische Anwendungen versprechen.

Zur Erörterung der Funktion des erfindungsgemäßen Verbindungssystems sind in Fig.3 und 4 die Kohlenstoff-Nanotubes durch Linien symbolisch dargestellt. Der dort eingezeichnete Abstand zwischen den Nanotubes entspricht nicht der Realität, sondern ist übertrieben groß dargestellt.

Wird eine in erfindungsgemäßer Weise mit einer Nanotube-Schicht 5 versehene Anschlußfläche 3 auf eine Leiterbahn 4, die ebenfalls eine Nanotube-Schicht 6 trägt, aufgelegt und auf diese Leiterbahn 4 gedrückt, kommt es zu der in Fig.4 dargestellten Verzahnung der beiden Nanotube-Schichten 5,6: Die Nanotubes der einen Schicht 5,6 werden dabei in die Zwischenräume zwischen den Nanotubes der anderen Schicht 6,5 eingeschoben. Da die Nanotubes sehr dicht beisammen stehen, kommt es dabei zu einem engen Anliegen der Mantelflächen der Nanotubes der einen Schicht 5,6 an den Mantelflächen der Nanotubes der anderen Schicht 6,5, was einerseits zu einer innigen mechanischen reibschlüssigen Verbindung und andererseits zu einer großen und damit widerstandsarmen elektrischen Kontaktfläche zwischen den beiden Schichten 5,6 führt.

Die Lösung der Verbindung erfolgt ebenso einfach wie ihre Herstellung, indem die Anschlußfläche 3 bzw. der Bauteil 1 etwa in normaler Richtung zur Schaltungsträger-Oberfläche von dieser wegbewegt wird. Da wie eingangs bereits angeführt, Nanotubes mechanisch äußerst stabil sind, kann die erörterte reibschlüssige Verbindung praktisch beliebig oft hergestellt und wieder gelöst werden.

Die gegenständliche Erfindung ist völlig unabhängig von den Materialien der zu verbindenden Komponenten Anschlußfläche 3 und Schaltungsträger 2 bzw. Leiterbahn 4 einsetzbar. Lediglich beispielhaft können als Metalle für die Anschlußfläche 3 und die Leiterbahn 4 Kupfer, Platin, Aluminium od. dgl. angegeben werden. Als Beispiele für Materialien zur Ausbildung des Schaltungsträgers 2 können Keramik, Epoxidharz-Platten, Glasfaser-Platten und dgl. angegeben werden.

Desweiteren sind die Abmessungen der Nanotubes beliebig wählbar, bevorzugt werden diese Kohlenstoff-Nanotubes aber mit Längen 1 im Bereich zwischen 20 und 100µm, insbesondere im Bereich zwischen 20 und 50µm hergestellt. Beide Formen von Nanotubes, nämlich einerseits solche, die an ihren freien Enden geschlossen sind und andererseits solche, die an ihren freien Enden offen sind, können zur Realisierung der gegenständlichen Erfindung herangezogen werden.

Die Größe der Nanotube-Schichten 5,6 ist nach oben nur durch die Dimensionen der Leiterbahnen 4 bzw. der Anschlußflächen 3 der Bauteile 1 beschränkt. Je großflächiger die Nanotube-Schichten 5,6 ausgeführt sind, desto inniger wird die mechanische Verbindung von Anschlußfläche 3 und Leiterbahn 4, sodaß es günstig ist, die gesamte zur Verfügung stehende Fläche von Leiterbahn 4 und Anschlußfläche 3 mit Nanotubes zu beschichten.

Die Herstellung der Kohlenstoff-Nanotube-Schichten 5,6 ist ebenfalls beliebig nach irgendeinem für sich im Stand der Technik dafür bekannten Verfahren, wie z.B. einem CVD-Verfahren, durchführbar. Nachdem es bei derartigen Verfahren notwendig ist, die (metallische) Oberfläche, auf welcher Nanotubes aufwachsen sollen, relativ stark, nämlich auf bis zu 1000°C, aufzuheizen, empfiehlt es sich, die Anschlußfläche 3 zuerst mit Nanotubes zu beschichten und erst nach Abschluß dieses Beschichtungsschrittes die Anschlußfläche 3 arn Bauteil 1 festzulegen. Vorstellbar ist auch, daß das Substrat gekühlt wird und nur das Reaktionsgas auf die für den Prozeß notwendige Temperatur erwärmt. Dadurch ist eine direkte Abscheidung auf dem Bauteil, d.h. eine Abscheidung auf bereits arn Bauteil festgelegten Anschlußflächen denkbar.

Weiters ist es möglich, eine Nanotube-Schicht zunächst auf einem von der Bauteil-Anschlußfläche verschiedenen Substrat aufwachsen zu lassen und diese Schicht nach abgeschlossener Herstellung auf die eigentliche Anschlußfläche des Bauteiles zu übertragen, was z.B. mittels einer Transfertechnik durchführbar ist.

Eine solche Transfertechnik für Nanotube-Schichten wurde beschrieben in der Australischen provisional application Nr. PQ 0650/99 vom 28. Mai 1999, Titel: "Substrate Supported Aligned Carbon Nanotube Films", Anmelder: Forschungsinstitutes CSIRO.

Die Erfindung ist bei jedem beliebigen elektrischen/elektronischen Bauteil 1 anwendbar, besonders vorteilhaft wirkt sie sich natürlich bei Bauteilen mit relativ vielen Anschlußflächen 3, wie z.B. Mikroprozessoren, Speicherbausteinen od. dgl. aus.

Ohne diese Erfindung in irgendeiner Weise einzuschränken wird abschließend der Ablauf einer tatsächlich durchgeführten Vorgangsweise zur Erzeugung einer Schicht von Kohlenstoff-Nanotubes auf einer aus Platin gebildeten Anschlußfläche 3 beschrieben.

Ferrocen wurde in Aceton aufgelöst und ein paar Tropfen dieser gesättigten Aceton-Lösung wurden auf die Oberfläche der Platin-Anschlußfläche aufgebracht, welche Anschlußfläche noch nicht auf einem elektrischen/elektronischen Bauteil festgelegt war. Das Aceton verdampfte langsam, was zur Bildung einer mikrokristallinen Ferrocen-Schicht auf der Substratoberfläche führte.

Die Platin-Anschlußfläche wurde anschließend in einen CVD-Ofen eingebracht, dessen Innenraum zunächst l5min lang mit Stickstoff gespült wurde. Danach wurde Acetylen als kohlenstoffhältiges Trägergas in den Ofen-Innenraum eingebracht, was ebenfalls durch Spülung des Ofen-Innenraumes mit diesem Trägergas durchgeführt wurde. Der Acetylen-Gasstrom wies dabei eine Strömungsgeschwindigkeit von etwa 15 sccm min⁻¹ auf

Jetzt wurde der Innenraum auf 650°C aufgeheizt. Beim Erreichen dieser Temperatur setzte die Abscheidung von Kohlenstoff auf der Oberfläche der Platin-Anschlußfläche und damit das Wachstum von Nanotubes auf dieser Anschlußfläche ein, was erkennbar war an der Bildung einer homogenen schwarzen Schicht. Die erörterten Prozeßbedingungen (Spülung mit Acetylen und Heizen der Platin-Anschlußfläche auf 650°C) wurden 40 Minuten lang aufrecht erhalten, danach wurde der Ofen-Innenraum mittels eines Stickstoff-Gasstromes auf Raumtemperatur abgekühlt.

Die Anschlußfläche 3 wurde dem Ofen entnommen und arn elektrischen/elektronischen Bauteil 1 angebracht.

Die Nanotube-Schicht 6 auf den Leiterbahnen 4 wurde in ähnlicher Weise mittels eines CVD-Verfahrens aufgebracht. In diesem Zusammenhang ist zu betonen, daß die Abscheidung von Kohlenstoff in Gestalt von Nanotubes nur auf metallischen Oberflächen einsetzt. Sollen Nanotubes auf einer nichtmetallischen Oberfläche aufwachsen gelassen werden, muß ein metallhältiger Katalysator, wie z.B. Ferrocen, auf diese Oberfläche aufgebracht werden.

Für den gegenständlichen Anwendungsfall bedeutet dies, daß wenn kein Katalysator auf den aus einem Nichtmetall bestehenden Schaltungsträger 2 aufgebracht wird, systembedingt nur auf den Leiterbahnen 4 Nanotube-Schichten entstehen können. Sollen diese nicht vollflächig mit einer Nanotube-Schicht belegt werden (was den Vorteil hätte, daß an beliebigen Stellen Anschlußflächen 3 auf ihnen festgelegt werden könnten), müssen die nicht zu beschichtenden Bereiche abgedeckt werden.

Wird ein aus einem keramischen Material bestehender Schaltungsträger 2 verwendet, welcher Platin-Leiterbahnen trägt, kann mit einem CVD-Verfahren, das die eben im Zusammenhang mit der Beschichtung einer Platin-Anschlußfläche 3 erörterten Prozeßparameter aufweist, eine Nanotube-Schicht 6 auf diesen Leiterbahnen 4 gebildet werden.

## Patentansprüche

1. Verbindungssystem zur lösbaren Festlegung eines Anschlußkontaktes (3) eines elektrisch/elektronischen Bauteils (2) auf einer Leiterbahn (4) eines Schaltungträgers (2), **dadurch gekennzeichnet, daß** jener Oberflächen-Abschnitt des Anschlußkontaktes (3), welcher auf der Leiterbahn (4) zu liegen kommt einerseits und jener Oberflächen-Abschnitt der Leiterbahn (4), auf welcher der Anschlußkontakt (3) zu liegen kommt andererseits mit einer Schicht (5,6) aus Kohlenstoff-Nanotubes belegt ist.

2. Elektrischer/elektronischer Bauteil (1), umfassend zumindest einen Anschlußkontakt (3), der lösbar auf einer Leiterbahn (4) eines Schaltungsträgers (2) festlegbar ist, **dadurch gekennzeichnet, daß** jener Oberflächen-Abschnitt des Anschlußkontaktes (3), welcher auf der Leiterbahn (4) zu liegen kommt mit einer Schicht (5) aus Kohlenstoff-Nanotubes belegt ist.

3. Leiterbahn (4) aufgebracht auf einem Schaltungsträger (2), auf welcher ein Anschlußkontakt (3) eines elektrischen/elektronischen Bauteiles (1) lösbar festlegbar ist, **dadurch gekennzeichnet, daß** jener Oberflächen-Abschnitt der Leiterbahn (4), auf welchem der Anschlußkontakt (3) des elektrischen/elektronischen Bauteiles (1) zu liegen kommt, mit einer Schicht (5) aus Kohlenstoff-Nanotubes belegt ist.

4. Verbindungssystem, elektrischer/elektronischer Bauteil (1) bzw. Leiterbahn (4) nach Anspruch 1, 2 bzw. 3, **dadurch gekennzeichnet, daß** die Kohlenstoff-Nanotubes Längen im Bereich zwischen 20 und 100µm aufweisen.

5. Verbindungssystem, elektrischer/elektronischer Bauteil (1) bzw. Leiterbahn (4) nach Anspruch 4, **dadurch gekennzeichnet, daß** die Kohlenstoff-Nanotubes Längen im Bereich zwischen 20 und 50µm aufweisen.

6. Verbindungssystem, elektrischer/elektronischer Bauteil (2) bzw. Leiterbahn (4) nach einem der Ansprüche 1 bis 5, **dadurch gekennzeichnet, daß** die Kohlenstoff-Nanotubes an ihren freien Enden offen sind.

7. Verbindungssystem, elektrischer/elektronischer Bauteil (1) bzw. Leiterbahn (4) nach einem der Ansprüche 1 bis 5, **dadurch gekennzeichnet, daß** die Kohlenstoff-Nanotubes an ihren freien Enden geschlossen sind.

## Claims

1. A connection system for detachably fastening a terminal contact (3) of an electric/electronic component (2) to a strip conductor (4) of a circuit board (2), **characterized in that** the surface section of the terminal contact (3) which comes to lie on the strip conductor (4) on the one hand and the surface section of the strip conductor (4) on which the terminal contact (3) comes to lie on the other hand are covered with a layer (5, 6) made of carbon nanotubes.

2. An electric/electronic component (1), comprising at least one terminal contact (3) which can be fastened in a detachable manner to a strip conductor (4) of a circuit board (2), **characterized in that** the surface section of the terminal contact (3) which comes to lie on the circuit board (4) is covered with a layer (5) of carbon nanotubes.

3. A strip conductor (4) applied to a circuit board (2) to which a terminal contact (3) of an electric/electronic component (1) can be detachably fastened, **characterized in that** the surface section of the strip conductor (4) on which the terminal contact (3) of the electric/electronic component (1) comes to lie is covered with a layer (5) of carbon nanotubes.

4. A connection system, electric/electronic component (1) or strip conductor (4) according to claim 1, 2 or 3, **characterized in that** the carbon nanotubes have lengths in the region of between 20 and 100 µm.

5. A connection system, electric/electronic component (1) or strip conductor (4) according to claim 4, **characterized in that** the carbon nanotubes have lengths in the region of between 20 and 50 µm.

6. A connection system, electric/electronic component (1) or strip conductor (4) according to claim 1 to 5, **characterized in that** the carbon nanotubes are open at their free ends.

7. A connection system, electric/electronic component (1) or strip conductor (4) according to claim 1 to 5, **characterized in that** the carbon nanotubes are sealed at their free ends.

## Revendications

1. Système de connexion pour la fixation amovible d'un élément de contact (3) d'un composant électrique ou électronique (2) sur une piste (4) d'une plaquette de circuit (2), **caractérisé en ce que** la partie de surface de l'élément de contact (3) qui vient reposer sur la piste (4) et la partie de la surface de la piste (4) sur laquelle vient reposer l'élément de contact (3) sont recouvertes d'une couche (5, 6) de nanotubes de carbone.

2. Composant électrique ou électronique (1) comprenant au moins un élément de contact (3) pouvant être fixé de manière amovible sur une piste (4) d'une plaquette de circuit (2), **caractérisé en ce que** la partie de la surface de l'élément de contact (3) qui vient reposer sur la piste (4) est recouverte d'une couche (5) de nanotubes de carbone.

3. Piste (4) appliquée sur une plaquette de circuit (2), sur laquelle un élément de contact (3) d'un composant électrique ou électronique (1) peut être fixé de manière amovible, **caractérisée en ce que** la partie de surface de la piste (4) sur laquelle l'élément de contact (3) du composant électrique ou électronique (1) vient reposer est recouverte d'une couche (5) de nanotubes de carbone.

4. Système de connexion, composant électrique ou électronique (1) et piste (4) selon la revendication 1, 2 ou 3, **caractérisés en ce que** les nanotubes de carbone ont des longueurs comprises entre 20 et 100 µm.

5. Système de connexion, composant électrique ou électronique (1) et piste (4) selon la revendication 4, **caractérisés en ce que** les nanotubes de carbone ont des longueurs comprises entre 20 et 50 µm.

6. Système de connexion, composant électrique ou électronique (2) et piste (4) selon l'une quelconque des revendications 1 à 5, **caractérisés en ce que** les nanotubes de carbone sont ouverts à leurs extrémités libres.

7. Système de connexion, composant électrique ou électronique (1) et piste (4) selon l'une quelconque des revendications 1 à 5, **caractérisés en ce que** les nanotubes de carbone sont fermés à leurs extrémités libres.
